# EUROPÄISCHE PATENTSCHRIFT

(11) **EP 1 841 072 B1**
(45) Veröffentlichungstag und Bekanntmachung des Hinweises auf die Patenterteilung: **01.06.2016**
(21) Anmeldenummer: 06006789.9
(22) Anmeldetag: 30.03.2006
(51) Int. Cl.: G10L 19/24, H03M 7/30

(54) **Verfahren und Einrichtung zum Dekodieren von schichtkodierten Daten**
Method and apparatus for decoding layer encoded data
Procédé et dispotitif de décodage de données codées en couches

(43) Veröffentlichungstag der Anmeldung: 03.10.2007
(73) Patentinhaber: Unify GmbH & Co. KG, 81379 München (DE)
(72) Erfinder: Gartner, Martin, 82024 Taufkirchen (DE); Taddei, Hervé, Dr., 2273 EG Voorburg (NL)
(74) Vertreter: Fritzsche, Thomas

(56) Entgegenhaltungen:
- YINGWEI CHEN ET AL: "Channel adaptive prioritized transmission of layered video over wireless LAN" PERSONAL, INDOOR AND MOBILE RADIO COMMUNICATIONS, 2003. PIMRC 2003. 14TH IEEE PROCEEDINGS ON SEPT. 7-10, 2003, PISCATAWAY, NJ, USA,IEEE, Bd. 2, 7. September 2003 (2003-09-07), Seiten 2948-2952, XP010678566 ISBN: 0-7803-7822-9
- ZINK M ET AL: "P2P streaming using multiple description coded video" EUROMICRO CONFERENCE, 2004. PROCEEDINGS. 30TH RENNES, FRANCE AUG. 31 - SEPT. 3, 2004, PISCATAWAY, NJ, USA,IEEE, 31. August 2004 (2004-08-31), Seiten 240-247, XP010723597 ISBN: 0-7695-2199-1
- RUI ZHANG ET AL: "Switched error concealment and robust coding decisions in scalable video coding" IMAGE PROCESSING, 2000. PROCEEDINGS. 2000 INTERNATIONAL CONFERENCE ON SEPTEMBER 10-13, 2000, PISCATAWAY, NJ, USA,IEEE, Bd. 3, 10. September 2000 (2000-09-10), Seiten 380-383, XP010529483 ISBN: 0-7803-6297-7
- DONG H ET AL INSTITUTE OF ELECTRICAL AND ELECTRONICS ENGINEERS: "Speech coding for mobile ad hoc networks" CONFERENCE RECORD OF THE 37TH. ASILOMAR CONFERENCE ON SIGNALS, SYSTEMS, & COMPUTERS. PACIFIC GROOVE, CA, NOV. 9 - 12, 2003, ASILOMAR CONFERENCE ON SIGNALS, SYSTEMS AND COMPUTERS, NEW YORK, NY : IEEE, US, Bd. VOL. 1 OF 2. CONF. 37, 9. November 2003 (2003-11-09), Seiten 280-284, XP010701700 ISBN: 0-7803-8104-1
- CUENCA P ET AL: "Packing scheme for layered coding MPEG-2 video transmission over ATM based networks" IEEE ATM WORKSHOP 1997. PROCEEDINGS LISBOA, PORTUGAL 25-28 MAY 1997, NEW YORK, NY, USA,IEEE, US, 25. Mai 1997 (1997-05-25), Seiten 168-177, XP010247401 ISBN: 0-7803-4196-1
- TADDEI H ET AL: "A SCALABLE THREE BIT-RATES 8-14.1-24 KBIT/S AUDIO CODER CODEUR AUDIO HIERARCHIQUE (8-14,1 - 24 KBIT/S)" ANNALES DES TELECOMMUNICATIONS - ANNALS OF TELECOMMUNICATIONS, GET LAVOISIER, PARIS, FR, Bd. 55, Nr. 9/10, September 2000 (2000-09), Seiten 483-492, XP000968161 ISSN: 0003-4347
- INJONG RHEE ET AL: "Error Recovery for Interactive Video Transmission over the Internet", IEEE JOURNAL ON SELECTED AREAS IN COMMUNICATIONS, IEEE SERVICE CENTER, PISCATAWAY, US, vol. 18, no. 6, 1 June 2000 (2000-06-01), XP011055146, ISSN: 0733-8716
- HERVÃ CR TADDEI SIEMENS AG GERMANY: "High level description of the scalable 8-32 kbit/s algorithm submitted to the Qualification Test by Matsushita, Mindspeed and Siemens; D 214", ITU-T DRAFT STUDY PERIOD 2005-2008, INTERNATIONAL TELECOMMUNICATION UNION, GENEVA ; CH, vol. STUDY GROUP 16, 26 July 2005 (2005-07-26), pages 1-7, XP017408007,
- TADDEI H ET AL: "A SCALABLE THREE BIT-RATES 8-14.1-24 KBIT/S AUDIO CODER CODEUR AUDIO HIERARCHIQUE (8-14,1 - 24 KBIT/S)", ANNALES DES TELECOMMUNICATIONS - ANNALS OF TELECOMMUNICATIONS, GET LAVOISIER, PARIS, FR, vol. 55, no. 9/10, 1 September 2000 (2000-09-01), pages 483-492, XP000968161, ISSN: 0003-4347

## Beschreibung

In digitalen Kommunikationssystemen werden Audio-, Video- oder andere Nutzdaten in der Regel in kodierter Form übertragen. Häufig ist vorgesehen, die zu übertragenden Nutzdaten durch echtzeitfähige oder quasiechtzeitfähige Kodierungsverfahren zu komprimieren. Dabei wird in der Regel angestrebt, eine zu übertragende Datenmenge und damit eine Übertragungsrate möglichst zu reduzieren, ohne z.B. bei Audioübertragungen einen subjektiven Höreindruck zu sehr zu beeinträchtigen.

Zur Kodierung von Audio- und Sprachsignalen sind insbesondere zwei Klassen von Kodierverfahren bekannt. Zum Einen im Zeitbereich wirkenden Kodierverfahren, bei denen ein Kurvenverlauf des Audiosignals in der Zeit kodiert bzw. dekodiert wird, und zum Anderen im Frequenzraum wirkende Kodierverfahren, bei denen ein Frequenzverlauf des Audiosignals kodiert bzw. dekodiert wird. Ein Beispiel für Zeitbereich-Kodierverfahren sind die sog. CELP-Kodierverfahren (Code Excited Linear Prediction). Ein Beispiel für ein Frequenzraum-Kodierverfahren ist das sog. AAC-Verfahren (AAC: Advanced Audio Coding) der Moving Picture Expert Group (MPEG), das eine modifizierte diskrete Kosinustransformation anwendet. Ein weiteres Beispiel für ein Frequenzraum-Kodierverfahren ist das sog. TDAC-Verfahren (Time Domain Aliasing Cancellation).

Zeitbereich-Kodierverfahren werden häufig auch als "time domain coding" und Frequenzraum-Kodierverfahren häufig auch als "frequency domain coding" oder "transform coding" bezeichnet.

In vielen Fällen wird bei Frequenzraum-Kodierverfahren die sog. "overlap-add-Methode" angewandt, bei der Nutzdaten aus aufeinander folgenden Datenpaketen mit einem vorgegebenen Überlapp addiert werden.

Unter Datenpaketen seien hier und im Folgenden sowohl Datenpakete im Sinne einer paketorientierten Übertragung, z.B. IP-Pakete (IP: Internet Protocol) als auch sog. Datenrahmen oder Daten-Frames verstanden.

Die overlap-add-Methode ist insofern vorteilhaft, als sie eine verhältnimäßig originalgetreue Rekonstruktion eines Audiosignals erlaubt, das durch paketweise übertragene Frequenzdaten kodiert ist. Durch die overlap-add-Methode werden Kodierungsartefakte korrigiert, die durch eine begrenzte Paket- oder Rahmenlänge bedingt sind.

Nachteilig ist jedoch, dass zur endgültigen Dekodierung eines Datenpakets erst das jeweils nachfolgende Datenpaket abzuwarten und in die Dekodierung mit einzubeziehen ist. Dadurch vergrößert sich die Dekodierverzögerung erheblich. So erhöht sich z.B. bei einer Paketlänge von 20 ms die Dekodierverzögerung auf 40 ms, falls die overlap-add-Methode angewandt wird.

Diese Erhöhung der Dekodierverzögerung wirkt sich insbesondere nachteilig auf die Rahmenfehlerrate von VoIP-Anwendungen (VoIP: Voice/Video over Internet Protocol) aus. Bei einer VoIP-Anwendung ist in der Regel eine Maximalwartezeit vorgesehen, während der auf ein Datenpaket gewartet wird. Falls ein erwartetes Datenpaket nicht innerhalb dieser Maximalwartezeit eintrifft, wird dies in der Regel als Paketverlust gewertet. Derartige Paketverluste treten insbesondere in Kommunikationsnetzen mit hohen Laufzeitschwankungen (Jitter) auf.

Zum Ausgleich derartiger Laufzeitschwankungen und damit zur Verringerung der Paketverlustrate kann ein vergrößerter Jitter-Pufferspeicher vorgesehen werden. Durch einen vergrößerten Jitter-Pufferspeicher wird jedoch auch die Übertragungsverzögerung erhöht, was sich wiederum negativ auf die Echtzeiteigenschaften der Audioübertragung auswirkt.

In INJONG, RHEE ET AL: "Error Recovery for Interactive Video Transmission over the Internet", IEEE JOURNAL ON SELECTED AREAS IN COMMUNICATIONS, IEEE SERVICE CENTER, PISCATAWAY, US, vol. 18, no. 6, 1 June 2000 (2000-06-01), XP011055146, ISSN: 0733-8716, wird ein Verfahren zur Fehlerbehandlung von interaktiven Videoübertragungen über das Internet offenbart, bei dem Datenpakete, die später als ihre Anzeigezeiten ankommen, nicht unberücksichtigt bleiben, sondern benutzt werden, um die Fehlerfortpflanzung zu reduzieren.

Aus YINGWEI, CHEN ET AL: "Channel adaptive prioritized transmission of layered video over wireless LAN" PERSONAL, INDOOR AND MOBILE RADIO COMMUNICATIONS, 2003. PIMRC 2003. 14TH IEEE PROCEEDINGS ON SEPT. 7-10, 2003, PISCATAWAY, NJ, USA,IEEE, Bd. 2, 7. September 2003 (2003-09-07), Seiten 2948-2952, XP010678566, ISBN: 0-7803-7822-9, ist ein Kodierverfahren für eine robuste Videoübertragung über WLAN bekannt, bei dem gestaffelte und prioritäre Übertragungsmechanismen benutzt werden.

Bei bisher bekannten Dekodierverfahren wird bei Überschreiten der maximalen Wartezeit ein Paketverlust konstatiert und eine durch den Paketverlust bedingte Lücke im Audioausgabestrom durch Verlängern und/oder Wiederholen eines oder mehrerer vorangegangener Audiopakete oder durch Schätzung oder Extrapolation des fehlenden Audiopaket gefüllt. Dies geht jedoch in der Regel mit einer hörbaren Verschlechterung der Wiedergabequalität einher.

Es ist Aufgabe der vorliegenden Erfindung ein Verfahren zum Dekodieren von kodierten Nutzdaten anzugeben, das durch Laufzeitschwankungen der Nutzdaten weniger beeinträchtigt wird. Es ist weiterhin Aufgabe der Erfindung eine Dekodiereinrichtung zur Durchführung des Verfahrens anzugeben.

Gelöst wird diese Aufgabe durch ein Verfahren mit den Verfahrensschritten des Patentanspruchs 1 sowie durch eine entsprechende Dekodiereinrichtung gemäß Patentanspruch 5.

Erfindungsgemäß werden durch Basisdaten und Verfeinerungsdaten kodierte Nutzdaten dekodiert, wobei die Basisdaten mit einer dekodierbedingten, ersten Verzögerung dekodiert werden, und die Verfeinerungsdaten mit einer dekodierbedingten, zweiten Verzögerung dekodiert werden, die größer ist als die erste Verzögerung. Die Nutzdaten können insbesondere in Echtzeit zu übertragende Sprachdaten, Audiodaten, Videodaten oder andere Kommunikationsdaten sein. Die Basisdaten können z.B. gemäß einem CELP-Verfahren kodierte Datenkodes sein. Als Verfeinerungsdaten können gemäß dem TDAC-Verfahren kodierte Datenkodes verwendet werden. Insbesondere können die Basisdaten gemäß einem Zeitbereich-Kodierverfahren kodierte Datenkodes und die Verfeinerungsdaten gemäß einem Frequenzraum-Kodierverfahren kodierte Datenkodes sein.

Erfindungsgemäß wird geprüft, ob die Verfeinerungsdaten einer Zeitvorgabe entsprechend verfügbar sind. Bei positivem Prüfungsergebnis werden die dekodierten Basisdaten zusätzlich verzögert, die zusätzlich verzögerten dekodierten Basisdaten mit den dekodierten Verfeinerungsdaten gemischt und daraus resultierende Mischungsdaten als Nutzdaten ausgegeben. Dagegen werden bei negativem Prüfungsergebnis die dekodierten Basisdaten als Nutzdaten ausgegeben.

Das erfindungsgemäße Dekodierverfahren und die erfindungsgemäße Dekodiereinrichtung wird durch Laufzeitschwankungen der kodierten Nutzdaten erheblich weniger beeinträchtigt als bekannte Dekodierverfahren und Dekodiereinrichtungen. Bei außerhalb der Zeitvorgabe eintreffenden Verfeinerungsdaten wird in vielen Fällen kein Paketverlust konstatiert, sondern es werden stattdessen die dekodierten Basisdaten als Nutzdaten ausgegeben. Die dekodierten Basisdaten allein weisen zwar häufig eine geringere Übertragungstreue als anhand von Basis- und Verfeinerungsdaten rekonstruierte Nutzdaten auf, doch ist die Übertragungstreue der dekodierten Basisdaten in der Regel noch erheblich besser, als diejenige von künstlich erzeugten Kompensationsdaten gemäß bekannten Dekodierverfahren.

Gemäß der Erfindung werden außerhalb der Zeitvorgabe verfügbare Verfeinerungsdaten zwischengespeichert und zum Dekodieren von nachfolgend eintreffenden Verfeinerungsdaten und/oder Basisdaten verwendet. Auf diese Weise können zu spät eintreffende Verfeinerungsdaten, die nicht mehr rechtzeitig dekodiert werden könnten, verwendet werden, um den Dekodiervorgang der nachfolgend eintreffenden Verfeinerungsdaten und/oder Basisdaten vorzubereiten oder zu initiieren oder zu deren Dekodierung unmittelbar verfügbar zu sein. Damit lässt sich in vielen Fällen erreichen, dass ein zu spät eintreffendes Datenpaket mit Verfeinerungsdaten nur die Dekodierung dieses Datenpakets und nicht auch eines anderen Datenpakets beeinträchtigt.

Bis zum Eintreffen der nachfolgenden Verfeinerungsdaten und/oder Basisdaten werden die dekodierten Basisdaten zusätzlich verzögert und die zusätzlich verzögerten dekodierten Basisdaten als Nutzdaten ausgegeben. Durch die zusätzliche Verzögerung können die Basisdaten zeitschlüssig mit den nachfolgenden Verfeinerungsdaten und/oder Basisdaten dekodiert werden.

Vorteilhafte Ausführungsformen und Weiterbildungen der Erfindung sind in den abhängigen Ansprüchen angegeben.

Nach einer vorteilhaften Ausführungsform der Erfindung können die Basisdaten und die Verfeinerungsdaten in Datenpaketen oder Datenrahmen eintreffen, wobei die Dekodierung der Basisdaten paketweise und die Dekodierung von Verfeinerungsdaten eines Datenpakets anhand von Verfeinerungsdaten eines weiteren Datenpakets erfolgen.

Weiterhin kann eine jeweilige Ankunftszeit der Basisdaten und/oder der Verfeinerungsdaten ermittelt werden und abhängig von der ermittelten Ankunftszeit zwischen einer Ausgabe der dekodierten Basisdaten und einer Ausgabe der Mischungsdaten umgeschaltet werden. Auf diese Weise können Laufzeitschwankungen der Basisdaten und/oder Verfeinerungsdaten aktiv durch Umschalten zumindest teilweise ausgeglichen werden. Anstelle oder zusätzlich zu einer jeweiligen Ankunftszeit kann auch eine Veränderungstendenz der Ankunftszeiten ermittelt werden und abhängig von der ermittelten Veränderungstendenz zwischen der Ausgabe der dekodierten Basisdaten und der Ausgabe der Mischungsdaten umgeschaltet werden.

Ferner können die Dekodierung der Basisdaten und die Dekodierung der Verfeinerungsdaten gemäß einem hierarchischen Dekodierprinzip aufeinander aufbauen. Bei einer hierarchischen Kodierung bzw. Dekodierung bauen mehrere schichtweise angeordnete Kodierverfahren insofern aufeinander auf, als jede aufliegende Schicht ein jeweiliges Kodierergebnis der darunter liegenden Schicht verfeinert.

Gemäß einer Weiterbildung der Erfindung können mehrere Hierarchieebenen von Verfeinerungsdaten vorgesehen sein, die kaskadiert dekodiert und verzögert werden.

Vorteilhafte Ausführungsbeispiele der Erfindung werden nachfolgend anhand der Zeichnung näher erläutert.

Dabei zeigen jeweils in schematischer Darstellung:
Figur 1 eine erfindungsgemäße Dekodiereinrichtung,
Figur 2 ein Ablaufdiagramm zur Veranschaulichung eines erfindungsgemäßen Dekodierverfahrens und
Figur 3 eine kaskadierte Dekodiereinrichtung.

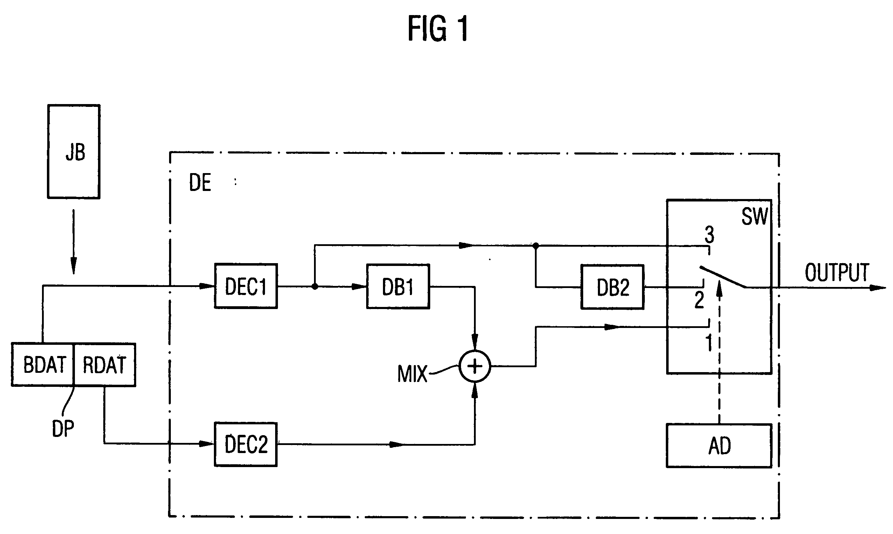

Figur 1 zeigt in schematischer Darstellung eine erfindungsgemäße Dekodiereinrichtung DE zum Dekodieren von in Datenpaketen, z.B. IP-Paketen, übertragenen Nutzdaten. Die Nutzdaten können beispielsweise Audio- oder Sprachdaten, insbesondere im Rahmen einer Echtzeit-VoIP-Kommunikation sein. Die Datenpakete, von denen in Figur 1 ein Datenpaket DP beispielhaft dargestellt ist, werden über ein paketorientiertes Kommunikationsnetzwerk (nicht dargestellt), wie z.B. das Internet, empfangen und unterliegen dementsprechend gewissen Laufzeitschwankungen. Zum Ausgleich der Laufzeitschwankungen ist ein Jitter-Puffer JB vorgesehen, der der Dekodiereinrichtung DE als Eingangspufferspeicher vorgeschaltet ist. Im Jitter-Puffer JB werden aus dem Kommunikationsnetzwerk empfangene Datenpakete zwischengespeichert und können von der Dekodiereinrichtung DE ausgelesen werden. Die Dekodiereinrichtung DE weist einen Nutzdatenausgang OUTPUT auf, über den die dekodierten Nutzdaten ausgegeben werden.

Die Dekodiereinrichtung DE implementiert ein so genanntes hierarchisches oder skalierbares Kodierverfahren, bei dem ein Zeitbereich-Kodierverfahren, z.B. gemäß eines CELP-Verfahrens, mit einem Frequenzraum-Kodierverfahren, z.B. dem TDAC-Verfahren kombiniert wird. Das verwendete Frequenzraum-Kodierverfahren baut insofern hierarchisch auf das verwendete Zeitbereich-Kodierverfahren auf, als ein Dekodierergebnis des Zeitbereich-Kodierverfahrens durch ein Dekodierergebnis des Frequenzraum-Kodierverfahrens verfeinert wird. Das Kodierergebnis des Zeitbereich-Kodierverfahrens ist jedoch auch ohne Verfeinerung durch das Frequenzraum-Kodierverfahren unter geringer Qualitätseinbuße nutzbar.

Für das vorliegende Ausführungsbeispiel sei angenommen, dass die Dekodiereinrichtung DE einen ein CELP-Zeitbereich-Kodierverfahren implementierenden Dekoder DEC1 und einen das TDAC-Frequenzraum-Kodierverfahren implementierenden Dekoder DEC2 aufweist. Der nach dem CELP-Verfahren arbeitende Dekoder DEC1 macht Gebrauch von Bandbreitenerweiterungstechniken im Zeitbereich und weist eine dekodierbedingte algorithmische Verzögerung von z.B. 29 ms auf.

Unter einer dekodierbedingten Verzögerung eines jeweiligen Dekoders DEC1 oder DEC2 sei diejenige Verzögerung verstanden, um die durch den Dekoder dekodierte Nutzdaten gegenüber den diesem Dekoder DEC1 bzw. DEC2 zugeführten Nutzdaten verzögert sind.

Der nach dem TDAC-Verfahren arbeitende Dekoder DEC2 führt eine Fourier-Transformation der jeweils zugeführten Nutzdaten durch und macht Gebrauch von der sog. Overlap-add-Methode. Der Decoder DEC2 ist somit ein sog. Transform-Decoder.

Im Datenpaket DP sind als kodierte Nutzdaten gemäß dem CELP-Verfahren kodierte Basisdaten BDAT sowie gemäß dem TDAC-Verfahren kodierte Verfeinerungsdaten RDAT enthalten. Die Verfeinerungsdaten RDAT bauen auf den Basisdaten BDAT im Sinne einer hierarchischen Kodierung auf. Die Basisdaten BDAT werden dem Dekoder DEC1 zugeführt und die Verfeinerungsdaten RDAT dem Dekoder DEC2. Beide Dekoder DEC1 und DEC2 dekodieren die jeweils zugeführten Nutzdaten BDAT bzw. RDAT im Parallelbetrieb. Während der Dekoder DEC1 die in dem Datenpaket DP enthaltenen Basisdaten BDAT unabhängig von in anderen Datenpaketen enthaltenen Basisdaten dekodieren kann, benötigt die Dekodierung der Verfeinerungsdaten RDAT des Datenpakets DP zusätzlich noch Verfeinerungsdaten des nachfolgenden Datenpakets.

Durch den Bedarf von Verfeinerungsdaten eines nachfolgenden Datenpakets ist die dekodierbedingte Verzögerung des Dekoders DEC2 um die Rahmenlänge eines Datenpakets, z.B. 20 ms, größer als die dekodierbedingte Verzögerung des Dekoders DEC1. Für das vorliegende Ausführungsbeispiel sei angenommen, dass die dekodierbedingte Verzögerung des Dekoders DEC2 entsprechend 29 ms + 20 ms = 49 ms beträgt.

Eine derartige hierarchische Anordnung eines CELP-basierten Dekoders, hier DEC1, und eines TDAC-basierten Dekoders, hier DEC2, wird gegenwärtig im Rahmen der ITU-T Empfehlung G.729EV diskutiert.

In bekannten Dekodiereinrichtungen hätte die verhältnismäßig größe Verzögerung des Dekoders DEC2 einen negativen Einfluss auf die Rahmenfehlerrate von VoIP-Anwendungen, da diese nur eine vorgegebene Maximalwartezeit auf ein Datenpaket mit kodierten Nutzdaten warten und einen erfolglosen Ablauf dieser Maximalwartezeit als Paketverlust werten. Dekoder mit höherer algorithmischer Verzögerung führen in Netzwerken mit Laufzeitschwankungen zu einer höheren Paketverlustrate.

Im Unterschied dazu erlaubt die Erfindung, auch bei ausbleibenden Verfeinerungsdaten, in vielen Fällen noch ein auf den Basisdaten basierendes Nutzsignal in akzeptabler Qualität auszugeben. Darüber hinaus können zu spät eintreffende Verfeinerungsdaten in vielen Fällen noch dazu verwendet werden, nachfolgend eintreffende Verfeinerungsdaten zu dekodieren und so eine eventuelle Qualitätseinbuße auf eine Rahmenlänge zu begrenzen.

Zum zumindest teilweisen Ausgleich des Unterschieds zwischen der dekodierbedingten Verzögerung des Dekoders DEC1 und der dekodierbedingten Verzögerung des Dekoders DEC2 ist ein Pufferspeicher DB1 vorgesehen, dessen Eingang mit einem Ausgang des Dekoders DEC1 gekoppelt ist. Der Pufferspeicher DB1 verzögert die vom Dekoder DEC1 dekodierten Basisdaten BDAT um die Differenz der dekodierbedingten Verzögerungen der Dekoder DEC1 und DEC2, d.h. um eine Rahmenlänge, hier 20 ms, des Datenpakets DP.

Der Ausgang des Pufferspeichers DB1 sowie ein Ausgang des Dekoders DEC2 sind mit einer Mischeinrichtung MIX gekoppelt zum Mischen der dekodierten, durch den Pufferspeicher DB1 verzögerten Basisdaten BDAT und der vom Dekoder DEC2 dekodierten Verfeinerungsdaten RDAT. Die resultierenden Mischungsdaten werden im Normalbetrieb, d.h. so lange die Nutzdaten enthaltenden Datenpakete rechtzeitig eintreffen, als die dekodierten Nutzdaten ausgegeben.

Zur Veranschaulichung des Zeitablaufs sei der Empfang eines N-ten Datenpakets mit kodieren Nutzdaten betrachtet. Während der Dekoder DEC1 das N-te Datenpaket unmittelbar dekodieren kann, kann der Dekoder DEC2 anhand des N-ten Datenpakets erst das N-1-te Datenpaket dekodieren. Falls das N-te Datenpaket nicht rechtzeitig, aber höchstens mit einer Verzögerung von einer Rahmenlänge, hier 20 ms, eintrifft, kann dieses zu spät eintreffende N-te Datenpaket noch vom Dekoder DEC1 rechtzeitig dekodiert und ausgegeben werden.

Die zeitliche Relation der Verarbeitungsschritte des N-ten Datenpakets und nachfolgender Datenpakete wird durch nachstehende Tabelle veranschaulicht:

| | | | |
|---|---|---|---|
| Verfügbares Datenpaket | N | N+1 | N+2 |
| Von DEC1 dekodierbar | N | N+1 | N+2 |
| Von DB1 ausgegeben | N-1 | N | N+1 |
| Von DEC2 dekodierbar | N-1 | N | N+1 |
| Am OUTPUT verfügbar | N-1 | N | N+1 |

Zur Prüfung eines rechtzeitigen Eintreffens eines jeweiligen Datenpakets DP weist die Dekodiereinrichtung DE einen Verfügbarkeitsdetektor AD auf. Der Verfügbarkeitsdetektor AD prüft, ob ein jeweiliges Datenpaket DP und damit die Verfeinerungsdaten RDAT rechtzeitig, d.h. einer Zeitvorgabe entsprechend verfügbar sind. Eine derartige Zeitvorgabe kann z.B. durch Echtzeitanforderungen einer VoIP-Anwendung vorgegeben werden.

Der Verfügbarkeitsdetektor AD ist mit einer Schalteinrichtung SW mit drei Schalterstellungen 1, 2 und 3 gekoppelt. Abhängig von der Schalterstellung 1, 2 oder 3 werden verschiedene Signale der Dekodiereinrichtung DE zum Nutzdatenausgang OUTPUT durchgeschaltet. Die jeweils einzunehmende Schalterstellung 1, 2 oder 3 wird vom Verfügbarkeitsdetektor AD abhängig von der Verfügbarkeit des jeweiligen Datenpakets DP bzw. der Verfeinerungsdaten RDAT gesteuert.

Dem der Schalterstellung 1 zugeordneten Anschluss der Schalteinrichtung SW werden die resultierenden Mischungsdaten der Mischeinrichtung MIX zugeführt. Der der Schalterstellung 3 zugeordnete Anschluss der Schalteinrichtung SW ist unmittelbar mit dem Ausgang des Dekodierers DEC1 gekoppelt. Der der Schalterstellung 2 zugeordnete Anschluss der Schalteinrichtung SW ist mit dem Ausgang des Dekoders DEC1 über einen Pufferspeicher DB2 gekoppelt. Durch den Pufferspeicher DB2 werden die vom Dekoder DEC1 dekodierten Basisdaten BDAT um eine Rahmenlänge, hier 20 ms, verzögert.

Wie oben schon erwähnt, prüft der Verfügbarkeitdetektor AD, ob die Verfeinerungsdaten RDAT bzw. das Datenpaket DP rechtzeitig verfügbar sind. Falls dies der Fall ist, d.h. infolge eines positiven Prüfungsergebnisses wird die Schalteinrichtung SW in die Schalterstellung 1 gesteuert, in der die Schalteinrichtung SW die Mischungsdaten zum Nutzdatenausgang OUTPUT durchschaltet. Falls die Verfeinerungsdaten RDAT nicht rechtzeitig verfügbar sind, d.h. infolge eines negativen Prüfungsergebnisses wird die Schalteinrichtung SW in die Schalterstellung 2 oder 3 gesteuert. In der Schalterstellung 3 schaltet die Schalteinrichtung SW unmittelbar die vom Dekoder DEC1 dekodierten Basisdaten BDAT zum Nutzdatenausgang OUTPUT durch. In der Schalterstellung 2 schaltet die Schalteinrichtung SW die vom Dekoder DEC1 dekodierten und zusätzlich durch den Pufferspeicher DB2 verzögerten Basisdaten BDAT zum Nutzausdatenausgang OUTPUT durch.

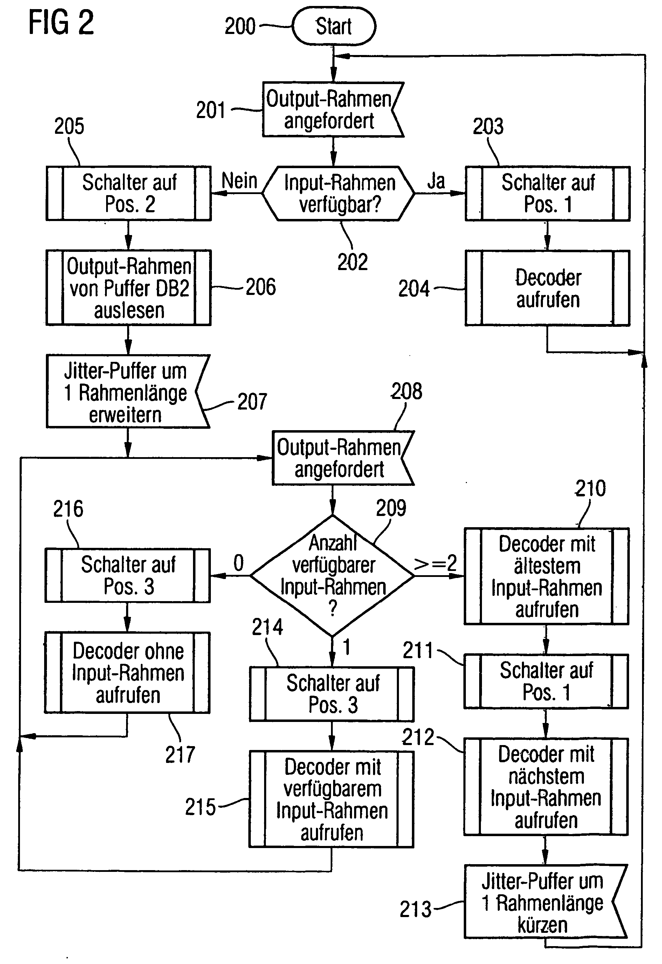

Figur 2 zeigt ein Ablaufdiagramm zur Veranschaulichung der Verfahrensschritte des erfindungsgemäßen Dekodierverfahrens.

Ausgehend vom Verfahrensstart 200 wird in einem Verfahrensschritt 201 ein Output-Rahmen am Nutzdatenausgang OUTPUT z.B. von einer VoIP-Anwendung mit einer bestimmten Zeitvorgabe angefordert. Im Verfahrensschritt 202 wird durch den Verfügbarkeitsdetektor AD geprüft, ob im Jitter-Puffer JB ein Input-Rahmen, d.h. ein Datenpaket DP aktuell auslesbar und damit verfügbar ist. Falls dies der Fall ist, wird in einem Verfahrensschritt 203 die Schalteinrichtung SW in die Schalterstellung 1 gebracht. Anschließend werden in einem Verfahrensschritt 204 die Dekoder DEC1 und DEC2 aufgerufen, d.h. dazu veranlasst, die in dem aus dem Jitter-Puffer JB ausgelesenen Datenpaket DP enthaltenen Basisdaten BDAT bzw. Verfeinerungsdaten RDAT zu dekodieren. Anschließend erfolgt ein Rücksprung zum Verfahrensschritt 201.

Falls im Verfahrensschritt 202 festgestellt, dass im Jitter-Puffer JB kein Input-Rahmen aktuell verfügbar ist, wird die Schalteinrichtung SW in einem Verfahrensschritt 205 in die Schalterstellung 2 gebracht und anschließend ein Output-Rahmen aus dem Puffer-Speicher DB2 ausgelesen und über den Nutzdatenausgang OUTPUT ausgegeben. Anschließend wird in einem Verfahrensschritt 207 der Jitter-Puffer JB um eine Rahmenlänge, d.h. hier um 20 ms, erweitert, so dass sich eine mittlere Verzögerung des Jitter-Puffers JB um eine Rahmenlänge vergrößert.

Anschließend wird in einem Verfahrensschritt 208 anwendungsseitig erneut ein Output-Rahmen am Nutzdatenausgang OUTPUT angefordert. Infolgedessen wird durch den Verfügbarkeitsdetektor AD in einem Verfahrensschritt 209 geprüft, wie viele Input-Rahmen, d.h. Datenpakete DP im Jitter-Puffer JB aktuelle auslesbar und damit verfügbar sind. Falls kein Input-Rahmen verfügbar ist, wird die Schalteinrichtung SW in einem Verfahrensschritt 216 in die Schalterstellung 3 gebracht. Anschließend werden die Dekoder DEC1 und DEC2 ohne Input-Rahmen aufgerufen. Da in diesem Fall kein Datenpaket dekodiert werden kann, wird ein Paketverlust konstatiert. In diesem Fall können bekannte Verfahren zum Überbrücken einer entstehenden Nutzdatenlücke angewandt werden. Derartige Verfahren sind auch als "frame erasure concealment" bekannt. Nach dem Verfahrensschritt 217 wird zum Verfahrensschritt 208 zurückgesprungen.

Wenn der Verfügbarkeitsdetektor AD im Verfahrensschritt 209 feststellt, dass genau ein Input-Rahmen im Jitter-Puffer JB verfügbar ist, wird die Schalteinrichtung SW in einem Verfahrensschritt 214 in die Schalterstellung 3 gebracht und anschließend der Dekoder DEC1 mit den verfügbaren Basisdaten BDAT des Input-Rahmens aufgerufen. Die dekodierten Basisdaten BDAT werden direkt über den Nutzdatenausgang OUTPUT ausgegeben. Anschließend wird zum Verfahrensschritt 208 zurückgesprungen.

Wenn der Verfügbarkeitsdetektor AD feststellt, dass zwei oder mehr Input-Rahmen im Jitter-Puffer JB aktuell verfügbar sind, werden die Dekoder DEC1 und DEC2 in einem Verfahrensschritt 210 mit dem ältesten verfügbaren Input-Rahmen aufgerufen, wobei das resultierende Dekodierergebnis ignoriert wird. Anschließend wird die Schalteinrichtung SW in einem Verfahrensschritt 211 in die Schalterstellung 1 gebracht, und es werden die Dekoder DEC1 und DEC2 in einem Verfahrensschritt 212 mit dem nächsten Input-Rahmen aufgerufen. In der Schalterstellung 1 werden die resultierenden Mischungsdaten der Dekoder DEC1 und DEC2 über den Nutzdatenausgang OUTPUT ausgegeben. Anschließend wird in einem Verfahrensschritt 213 der Jitter-Puffer JB um eine Rahmenlänge, d.h. hier um 20 ms, gekürzt, so dass sich dessen mittlere Verzögerung um eine Rahmenlänge verringert. Anschließend wird zum Verfahrensschritt 201 zurückgesprungen.

Durch das vom Verfügbarkeitsdetektor AD gesteuerte Umschalten zwischen der Ausgabe der Mischungsdaten und der Ausgabe der decodierten Basisdaten BDAT wird durch die Erfindung eine akzeptable Rückfalllösung für Fälle bereitgestellt, in denen Datenpakete mit codierten Nutzdaten zu spät eintreffen und gemäß dem Stand der Technik verworfen würden. Die Erfindung führt zu einer Verbesserung der Dekodier- oder Wiedergabequalität gegenüber Dekodierverfahren, bei denen nicht rechtzeitig eintreffende Datenpakete verworfen werden. Erfindungsgemäß können bei einem nicht rechtzeitigen Eintreffen eines Datenpakets in vielen Fällen zumindest die Basisdaten BDAT zur Erzeugung eines akzeptablen Nutzsignals herangezogen werden.

Darüber hinaus werden nicht rechtzeitig eintreffende Datenpakete, insbesondere wenn diese nicht länger als eine Rahmenlänge gegenüber der Zeitvorgabe verspätet sind, erfindungsgemäß nicht verworfen, sondern der Dekodiereinrichtung DE zum Dekodieren zugeführt. Insbesondere werden die verspätet eintreffenden Verfeinerungsdaten RDAT eines verspäteten Datenpakets DP dem Dekoder DEC2 zum Dekodieren zugeführt. In der Regel können derart verspätete Verfeinerungsdaten RDAT zwar nicht mehr rechtzeitig in dekodierter Form ausgegeben werden, doch können diese Verfeinerungsdaten RDAT dazu verwendet werden, Verfeinerungsdaten aus einem nachfolgend rechtzeitig eintreffenden Datenpaket zu dekodieren. In diesem Fall kann bereits das nachfolgende Datenpaket wieder in hoher verfeinerter Qualität dekodiert werden.

Die Erfindung lässt sich in vielfältiger Weise ausgestalten und weiterbilden.

So kann der Dekoder DEC2 eine qualitativ besonders hochwertige Dekodierung mit einer entsprechend hohen dekodierbedingten Verzögerung vornehmen. In diesem Fall kann vorgesehen sein, aktuelle Echtzeitanforderungen einer Kommunikationsanwendung zu erfassen und abhängig davon zwischen dem Dekoder DEC2 und dem eine geringere dekodierbedingte Verzögerung aufweisenden Dekoder DEC1 umzuschalten.

Weiterhin kann im Fall, dass eine Summe aus dekodierbedingter Verzögerung und maximaler jitter-bedingter Paketlaufzeit begrenzt ist, vorgesehen sein, eine höhere jitter-bedingte Laufzeitverzögerung durch Umschalten auf den Dekoder DEC1 mit der geringeren dekodierbedingten Verzögerung zu kompensieren.

An Stelle von hierarchisch aufeinander aufbauenden Dekodern, können die Dekoder DEC1 und DEC2 als voneinander unabhängige Dekoder realisiert sein. So kann z.B. der Dekoder DEC1 zum Dekodieren von Datenpaketen mit 10 ms Rahmenlänge und der Dekoder DEC2 zum Dekodieren von Datenpaketen mit einer Rahmenlänge von 20 ms in einem breiteren Frequenzband ausgestaltet sein.

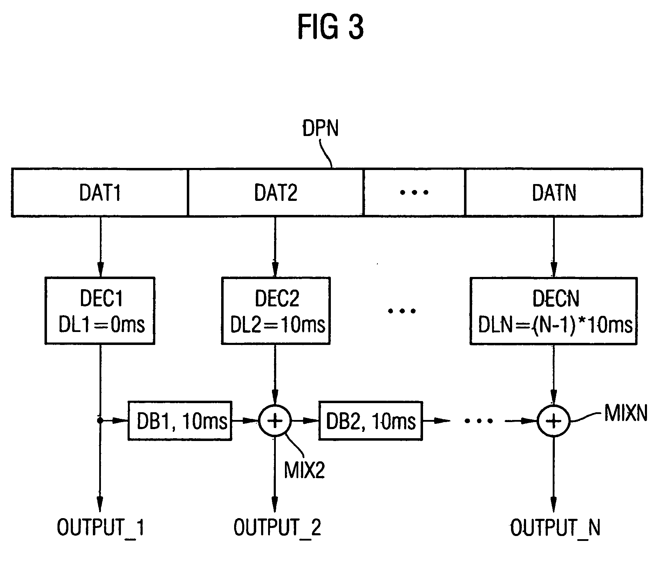

Nach einer Weiterbildung der Erfindung können mehrere Hierarchie-Ebenen von Verfeinerungsdaten vorgesehen sein, die kaskadiert dekodiert und verzögert werden. Eine derartige kaskadierte Dekodiereinrichtung ist in Figur 3 veranschaulicht.

Figur 3 zeigt ein Datenpaket DPN mit Basisdaten DAT1 und darauf jeweils hierarchisch aufbauenden Verfeinerungsdaten DAT2,...,DATN. Weiterhin sind hierarchisch aufeinander aufbauende Dekoder DEC1, DEC2,..., DECN mit unterschiedlichen dekodierbedingten Verzögerungen vorgesehen. Es sei angenommen, das der Dekoder DEC1 eine dekodierbedingte Verzögerung DL1 von 0 ms, der Dekoder DEC2 eine dekodierbedingte Verzögerung DL2 von 10 ms und entsprechend der Dekoder DECN eine dekodierbedingte Verzögerung DLN von (N-1) * 10 ms aufweisen. Weiterhin sind Pufferspeicher DB1, DB2,... zum zumindest teilweisen Ausgleich der Unterschiede zwischen den Verzögerungen DL1, DL2,... DLN als Verzögerungseinrichtungen vorgesehen. Die Pufferspeicher DB1, DB2,.... weisen im vorliegenden Ausführungsbeispiel jeweils eine Verzögerung von 10 ms auf. Darüber hinaus sind Mischeinrichtungen MIX2,..., MIXN jeweils mit einem Ausgang der Dekoder DEC2, ..., DECN gekoppelt.

Die im Datenpaket DPN enthaltenen, kodierten Nutzdaten werden den Dekodern DEC1, DEC2,..., DECN zugeführt, und zwar die Basisdaten DAT1, dem Dekoder DEC1, die Verfeinerungsdaten DAT2, dem Dekoder DEC2 und entsprechend die Verfeinerungsdaten DATN, dem Dekoder DECN. Der Dekoder DEC1 dekodiert die Basisdaten DAT1 und gibt die dekodierten Basisdaten DAT1 über einen Signalausgang OOUTPUT_1 aus. Die dekodierten Basisdaten DAT1 werden zusätzlich im Pufferspeicher DB1 zwischengespeichert, um 10 ms verzögert und die verzögerten dekodierten Basisdaten DAT1 der Mischeinrichtung MIX2 zugeführt.

Der Mischeinrichtung MIX2 werden darüber hinaus die vom Dekoder DEC2 mit der Verzögerung DL2 dekodierten Verfeinerungsdaten DAT2 zugeleitet. Das resultierende Mischungsergebnis wird von der Mischeinrichtung MIX2 über einen Signalausgang OUTPUT_2 ausgegeben und zusätzlich dem Pufferspeicher DB2 zugeführt. Der Pufferspeicher DB2 verzögert die dekodierten Verfeinerungsdaten DAT2 um 10 ms und führt die verzögerten dekodierten Verfeinerungsdaten DAT2 ggf. einer weiteren kaskadiert angeordneten Mischeinrichtung zu.

Der Mischeinrichtung MIXN werden schließlich die vom Dekoder DECN mit der Verzögerung DLN dekodierten Verfeinerungsdaten DATN sowie durch einen vorgeschalteten Pufferspeicher verzögerte dekodierte Verfeinerungsdaten zugeführt. Das resultierende Mischungsergebnis wird über einen Signalausgang OUTPUT_N ausgegeben.

An den Signalausgängen OUTPUT_1, OUTPUT_2,..., OUTPUT_N stehen somit sukzessive verfeinerte dekodierte Nutzdaten mit unterschiedlicher dekodierbedingter Verzögerung zur Verfügung. Je nach zeitlicher Verfügbarkeit des Datenpakets DPN oder abhängig von gestellten Echtzeitanforderungen kann einer der Signalausgänge OUTPUT_1, OUTPUT_2,..., OUTPUT_N zu einem Nutzsignalausgang der Dekodiereinrichtung durchgeschaltet werden.

## Patentansprüche

1. Verfahren zum Dekodieren in einer Dekodiereinrichtung (DE) von durch Basisdaten (BDAT) und Verfeinerungsdaten (RDAT) kodierten Nutzdaten, wobei
a) die Basisdaten (BDAT) gemäß einem Zeitbereich-Kodierverfahren kodierte Datenkodes und die Verfeinerungsdaten (RDAT) gemäß einem Frequenzraum-Kodierverfahren kodierte Datenkodes von Sprach- oder Audiodaten sind, die in einem Datenpaket (DP) mit einer Rahmenlänge enthalten sind,
b) die Basisdaten (BDAT) mit einer dekodierbedingten, ersten Verzögerung in einem ersten Dekoder (DEC1) dekodiert werden,
c) die Verfeinerungsdaten (RDAT) mit einer dekodierbedingten, zweiten Verzögerung in einem zweiten Dekoder (DEC2) dekodiert werden, die größer ist, als die erste Verzögerung,
d) zum Ausgleich von Laufzeitschwankungen in einem Kommunikationsnetzwerk für die kodierten Nutzdaten durch einen Verfügbarkeitsdetektor (AD) nach einer ersten Anforderung eines Output-Rahmens (201) geprüft wird, ob in einem vorgeschalteten Jitter-Pufferspeicher (JB) die Verfeinerungsdaten (RDAT) einer Zeitvorgabe entsprechend verfügbar sind, wobei
- bei positivem Prüfungsergebnis die dekodierten Basisdaten zusätzlich um eine Rahmenlänge verzögert werden, die zusätzlich verzögerten dekodierten Basisdaten mit den dekodierten Verfeinerungsdaten in einer Mischeinrichtung (MIX) gemischt werden und daraus resultierende Mischungsdaten als Nutzdaten über eine erste Schalterstellung (1) einer Schalteinrichtung (SW) ausgegeben werden, und
- bei negativem Prüfungsergebnis die dekodierten Basisdaten zusätzlich um eine Rahmenlänge verzögert als Nutzdaten über eine zweite Schalterstellung (2) der Schalteinrichtung (SW) ausgegeben werden und anschließend der Jitter-Pufferspeicher (JB) um eine Rahmenlänge erweitert (207) wird, wobei anschließend bei einer zweiten Anforderung eines Output-Rahmens (208), wenn im Jitter-Pufferspeicher (JB) zwei oder mehr Input-Rahmen verfügbar sind (209), der erste Dekoder (DEC1) und der zweite Dekoder (DEC2) mit den ältesten verfügbaren Input-Rahmen aufgerufen werden, wobei das resultierende Dekodierergebnis ignoriert wird (210), anschließend die Schalteinrichtung (SW) in die erste Schalterstellung (1) gebracht wird (211) und anschließend der erste Dekoder (DEC1) und der zweite Dekoder (DEC2) mit dem nächsten Input-Rahmen aufgerufen werden und die resultierenden Mischungsdaten der Mischeinrichtung (MIX) ausgegeben werden (212), und anschließend der Jitter-Pufferspeicher (JB) um eine Rahmenlänge gekürzt (213) wird.

2. Verfahren nach Anspruch 1,
**dadurch gekennzeichnet,**
**dass** die Basisdaten (BDAT) und die Verfeinerungsdaten (RDAT) in Datenpaketen (DP) eintreffen,
**dass** die Dekodierung der Basisdaten (BDAT) paketweise erfolgt, und
**dass** die Dekodierung von Verfeinerungsdaten (RDAT) eines Datenpakets (DP) anhand von Verfeinerungsdaten eines weiteren Datenpakets erfolgt.

3. Verfahren nach einem der vorhergehenden Ansprüche,
**dadurch gekennzeichnet,**
**dass** die Dekodierung der Basisdaten (BDAT) und die Dekodierung der Verfeinerungsdaten (RDAT) gemäß einem hierarchischen Dekodierprinzip aufeinander aufbauen.

4. Verfahren nach dem vorhergehenden Anspruch 4,
**dadurch gekennzeichnet,**
**dass** mehrere Hierarchieebenen von Verfeinerungsdaten (DAT2, DATN) vorgesehen sind, die kaskadiert dekodiert und verzögert werden.

5. Dekodiereinrichtung (DE) zur Durchführung des Verfahrens nach einem der Ansprüche 1 bis 4.

6. Verfahren nach einem der Ansprüche 1 bis 4 bzw. Dekodiereinrichtung (DE) nach Anspruch 5,
**dadurch gekennzeichnet,**
**dass** in der Dekodiereinrichtung (DE) das Kodierverfahren nach einem Zeitbereich-Kodierverfahren gemäß eines CELP-Verfahrens und dem Frequenzraum-Kodierverfahren gemäß dem TDAC-Verfahren, vorzugsweise mit der Overlap-add-Methode kombiniert wird.

## Claims

1. A method for decoding user data encoded by means of base data (BDAT) and refining data (RDAT) in a decoding device (DE), wherein
a) the base data (BDAT) are data codes encoded in accordance with a time range coding method, and the refining data (RDAT) are data codes encoded in a frequency domain method, of voice and audio data which are contained in a data packet (DP) of one frame length,
b) the base data (BDAT) are decoded in a first decoder (DEC1) using a decoding-conditional first delay,
c) the refining data (RDAT) are decoded in a second decoder (DEC2) using a decoding-conditional second delay which is longer than the first delay,
d) an availability detector (AD) performs a check after a first request of an output frame (201) if the refining data (RDAT) are available in an upstream jitter buffer (JB) in accordance with a time target to compensate runtime variations in a communications network for the encoded user data, wherein
- if the result of the check is positive, the decoded base data are delayed by an additional frame length, the additionally delayed decoded base data are mixed with the decoded refining data in a mixing device (MIX) and the resulting mixing data are outputted as user data via a first switch position (1) of a switching device (SW), and
if the result of the check is negative, the decoded base data are outputted as user data with an additional delay of one frame length via a second switch position (2) of the switching device (SW) and subsequently the jitter buffer (JB) is extended by one frame length (207), wherein subsequently, upon a second request of an output frame (208), if two or more input frames are available in the jitter buffer (JB) (209), the first decoder (DEC1) and the second decoder (DEC2) are called up with the oldest available input frames, wherein the resulting decoding result is ignored (210), then the switching device (SW) is brought into the first switch position (1) (211) and then the first decoder (DEC1) and the second decoder (DEC2) are called up with the next input frame and the resulting mixing data of the mixing device (MIX) are outputted (212), and then the jitter buffer (JB) is reduced by one frame length (213).

2. The method according to claim 1,
**characterized in that**
the base data (BDAT) and the refining data (RDAT) arrive in data packet (DP),
that the base data (BDAT) are decoded in a packet-oriented manner, and
that the decoding of the refining data (RDAT) of a data packet (DP) takes place with reference to refining data of a further data packet.

3. The method according to any one of the preceding claims, **characterized in that**
the decoding of the base data (BDAT) and the decoding of the refining data (RDAT) build on one another in accordance with a hierarchical decoding principle.

4. The method according to the preceding claim 4,
**characterized in that**
multiple hierarchies of refining data (DAT2, DATN) are provided which are decoded and delayed in a cascaded manner.

5. A decoding device (DE) for performing the method according to any one of claims 1 to 4.

6. The method according to any one of claims 1 to 4 or the decoding device (DE) according to claim 5, respectively,
**characterized in that**
in the decoding device (DE), the time range coding method according to a CELP method and the frequency domain coding method according to the TDAC method are preferably combined with the overlap add method.

## Revendications

1. Procédé de décodage dans un dispositif de décodage (DE) de données utiles codées par des données de base (BDAT) et des données d'affinage (RDAT),
a) les données de base (BDAT) selon un procédé de codage de plage temporelle étant des codes de données codés et les données d'affinage (RDAT) selon un procédé de codage d'espace de fréquence étant des codes de données codés de données vocales ou audio qui sont contenues dans un paquet de données (DP) avec une longueur d'encadrement,
b) les données de base (BDAT) étant décodées avec un premier retard dû au décodage dans un premier décodeur (DEC1),
c) les données d'affinage (RDAT) étant décodées avec un second retard dû au décodage dans un second décodeur (DEC2) qui est supérieur au premier retard,
d) pour la compensation d'oscillations de temps de parcours dans un réseau de communication pour les données utiles codées par un détecteur de disponibilité (AD) selon une première exigence d'un encadrement de sortie (201) étant vérifié si dans une mémoire intermédiaire de gigue (JB) montée en amont, les données d'affinage (RDAT) sont disponibles selon une prescription de temps,
- pour un résultat de contrôle positif, les données de base décodées sont retardées en outre d'une longueur d'encadrement, les données de base décodées retardées en outre étant mélangées avec les données d'affinage décodées dans un dispositif de mélange (MIX) et des données de mélange en résultant comme données utiles sont émises par une première position de commutation (1) d'un dispositif de commutation (SW) et
- pour un résultat de contrôle négatif, les données de base décodées sont émises retardées en outre d'une longueur d'encadrement comme données utiles par une seconde position de commutation (2) du dispositif de commutation (SW) et la mémoire intermédiaire de gigue (JB) est ensuite élargie (207) d'une longueur d'encadrement, ensuite pour une seconde exigence d'un encadrement de sortie (208) lorsque dans la mémoire intermédiaire de gigue (JB) deux ou plus encadrements d'entrée sont disponibles (209), le premier décodeur (DEC1) et le second décodeur (DEC2) étant appelés avec les plus anciens encadrements d'entrée disponibles, le résultat de décodage résultant étant ignoré (210), ensuite le dispositif de commutation (SW) étant amené (211) dans la première position de commutation (1) et ensuite le premier décodeur (DEC1) et le second décodeur (DEC2) étant appelés avec l'encadrement d'entrée suivant et les données de mélange résultantes du dispositif de mélange (MIX) étant émises (212) et ensuite la mémoire intermédiaire de gigue (JB) étant raccourcie d'une longueur d'encadrement (213).

2. Procédé selon la revendication 1,
**caractérisé en ce que**
les données de base (BDAT) et les données d'affinage (RDAT) arrivent dans des paquets de données (DP),
le décodage des données de base (BDAT) est effectué par paquet et
le décodage de données d'affinage (RDAT) d'un paquet de données (DP) est effectué à l'aide de données d'affinage d'un autre paquet de données.

3. Procédé selon l'une quelconque des revendications précédentes,
**caractérisé en ce que**
le décodage des données de base (BDAT) et le décodage des données d'affinage (RDAT) s'établissent l'un sur l'autre selon un principe de décodage hiérarchique.

4. Procédé selon la revendication précédente 4, **caractérisé en ce que**
plusieurs plans hiérarchiques de données d'affinage (DAT2, DATN) sont prévus, lesquels sont décodés et retardés en cascade.

5. Dispositif de décodage (DE) pour la réalisation du procédé selon l'une quelconque des revendications 1 à 4.

6. Procédé selon l'une quelconque des revendications 1 à 4 ou dispositif de décodage (DE) selon la revendication 5,
**caractérisé en ce que**
dans le dispositif de décodage (DE), le procédé de codage selon un procédé de codage de plage temporelle selon un procédé CELP et le procédé de codage d'espace de fréquence selon le procédé TDAC est combiné de préférence à la méthode Overlap-Add.
